# EUROPEAN PATENT APPLICATION

(11) **EP 4 485 700 A1**
(43) Date of publication of application: **01.01.2025**
(21) Application number: 23181652.1
(22) Date of filing: 27.06.2023
(51) Int. Cl.: H01R 12/58, H01R 13/658

(54) **SHIELDING DEVICE FOR ELECTROMAGNETIC SHIELDING**

(71) Applicant: Aptiv Technologies AG, 8200 Schaffhausen (CH)
(72) Inventor: HACKBARTH, Daniel, 81825 München (DE)
(74) Representative: Bardehle Pagenberg Partnerschaft mbB Patentanwälte Rechtsanwälte

(57) **Abstract**

The present invention relates to a shielding device (i) for electromagnetic shielding of a data transmission arrangement (3). The device comprised a housing (2) made from bent and stamped sheet-metal comprising at least one press-fit/ compliant pin (4) adapted for connecting the housing with a PCB (210). Further, a pair of signal lines (5, 6) is arranged inside the housing (2), so as to be electromagnetically shielded.

## Description

### 1. Field of the invention

The present invention relates to an electromagnetic shielding device for the continuous shielding of a conducting element, as e.g. a data transmission arrangement, such as signal cables.

### 2. Technical background

In many fields of applications, electrical cables and connections need to be electromagnetically shielded. In particular in the automotive industry signal transmission lines are required to handle increasingly high data transmission speeds. Due to the speeds involved, shielding of the connectors and cables is an essential need to avoid possible interferences and ensure the needed signal integrity in order to reach high speed data transmission. Often it is of importance to electrically connect the electromagnetic shielding of for example a signal transmission arrangement to the electromagnetic shielding of a housing or PCB to establish a shielding continuity. Due to the large demand for electrical components, e.g. in the field of automotive applications, such components have to be efficiently and inexpensively producible; however, they still have to fulfill high quality standards.

The known solutions for high speed data transmission rely on a shielding housing that is die cast, which is reliable and can be manufactured in mass production. However, such die cast solutions are relatively expensive and the possible shapes of the housings are limited due to the production process. Further, it is difficult to assemble the electrical conductive elements by pressfit/ compliant pin, such as e.g. signal lines, inside the shielding housing.

Subject of the present invention is to provide a new electromagnetic shielding device which minimizes or eliminates the above described problems. It is a further object of the invention to provide an electromagnetic shielding device which minimizes the required parts which are needed to manufacture the device and which preferably offers a facilitated mounting of the electrical conductors to be shielded. Further, it is an object of the invention to achieve all the advantages with an inexpensive product, which can preferably be made from a single piece of sheet-metal, which is required so pressfit/ compliant pins can be used for the PCB connection.

These and other objects which become apparent upon reading the following description are solved by an electromagnetic shielding device according to claim 1.

### 3. Summary of the invention

According to the invention, a shielding device for electromagnetic shielding of a data transmission arrangement is provided, which comprises a housing made from bent and stamped sheet-metal. The housing further comprises at least one press-fit/ compliant pin adapted for connecting the housing with a PCB, in particular to establish a connection of the housing with ground. Still further, a pair of signal lines is arranged inside the housing, so as to be electromagnetically shielded. By making the shielding housing out of sheet-metal, which is stamped and afterwards bent into the desired shape of the housing, an inexpensive and flexible production is possible. Further, the housing is provided with at least one press-fit/ compliant pin for establishing for example a ground connection of the housing with another electrical or electronic component, such as a PCB. The press-fit/ compliant pin advantageously may also serve to fasten the housing itself onto the other component. Preferably, the housing is provided with an even number of press-fit/ compliant pins, such as for example two or four.

Inside of the shielding housing at least one pair of signal lines is arranged, such that the lines are electromagnetically shielded. The skilled person will understand, that for an efficient electromagnetic shielding it is advantageous that the housing encloses the signal lines as complete as possible. Thus, it is advantageous that the housing comprises preferably no openings or only very few and small openings, apart from the necessary connecting or mating ends of the housing, which must be provided to allow connecting of the signal lines.

Generally preferred, the signal lines are adapted to enable data transmission of at least 5 GHz, preferably at least 10 GHz, more preferably at least 20 GHz and most preferably at least 50 GHz.

In a preferred embodiment, the press-fit/ compliant pin is integrally formed with the housing. Another advantage of using sheet-metal for the manufacturing of the housing is, that it is easily to integrally incorporate press-fit/ compliant pins with the housing walls. Typically, press-fit/ compliant pins are made from stamped sheet-metal, so that in the present invention it is possible to make the pins together with the rest of the housing in one manufacturing process. When for example stamping out the required shape of the housing from a piece of sheet-metal, also the press-fit/ compliant pins can be formed, extending for example integrally from an edge of a wall of the housing. It is therefore not necessary to assemble for example prefabricated press-fit/ compliant pins onto a die cast metallic housing, as in the prior art.

In a preferred embodiment, the shielding device has a 90° configuration for enabling a 90° connection of the pair of signal lines. In many applications, it is necessary to provide a 90° connection device for the signal lines, in contrast to for example a 180° connection. While the shielding of a 180° connection can be relatively simply achieved by a metal cylinder or bushing, the shielding effort for a 90° configuration is more challenging. The concept of using sheet-metal for the housing allows for a cost efficient and flexible manufacturing process, in particular for more complex shapes, as are necessary for such a 90° configuration.

Preferably, the housing further comprises a first cavity for receiving the first end of the signal lines, which defines a first direction, and a second cavity, for receiving the second end of the signal lines, which defines a second direction essentially perpendicular to the first direction. As the skilled person will understand, the shielding housing needs to be adapted to house the signal lines therein. The signal lines in turn are typically provided on their respective ends with means to establish an electrical connection with other components, such as other signal lines or electronic components, such as a PCB. To this end, the housing is shaped such that suitable cavities are formed for receiving the respective ends of the signal lines, such that it is possible to establish a connection. By arranging these cavities such that they define directions perpendicular to each other, again a 90° connection of the pair of signal lines is facilitated.

Further, preferred, the first cavity is formed by bending the sheet-metal into an oval cylindrical shape and the second cavity is formed by bending the sheet-metal into a box-shaped structure. The use of stamped and bend sheet-metal for the manufacturing of the housing is in particular advantageous for building basic geometric forms, such as tubes or essentially rectangular box shapes. The box shape structure is commonly preferred for the connecting end that is for example mounted to a PCB and the oval cylindrical shape, or tube shape, is preferred for a connecting end that is adapted for connecting with another connector, or another signal line, respectively.

In another preferred embodiment, the housing comprises at least one dedicated press-in surface, adapted to be engaged by a corresponding press-in tool. A dedicated surface facilitates an automatic mounting process of the shielding device onto for example a PCB. The surface is preferably arranged, such that the press-in forces of the tool are transferred in the plane of the wall of the housing and not at an angle thereto. Thereby, also high press-in forces can be handled by the relatively thin walls of the housing.

Preferably, the housing comprises locking apertures and corresponding locking protrusions, such that upon bending the housing into the dedicated shape, the locking apertures and locking protrusions interact to maintain the shape. The use of such locking means improves the structural stability of the housing. For example, when bending two portions of the stamped sheet-metal such that the two portions are perpendicular to each other, to form for example a corner of the housing, one of the portions may be provided with in an aperture and the other portion with a corresponding protrusion that fits into the aperture. In this way, it is for example possible to advantageously make use of the spring properties of the sheet-metal, so that for example the protrusion interlocks with the aperture. Further preferred, the protrusion may be in addition for example be provided with a hook, that interacts with the edge of the aperture, to prevent and undesired removal of the protrusion out of the aperture.

In a preferred embodiment, the housing comprises interacting locking elements in form of a dovetail connection, such that upon bending the housing into the dedicated shape, the dovetail connection acts to maintain the shape. The use of such dovetail elements increases the structural stability of the housing. For example, when the stamped sheet-metal is bent into the desired form, two edges adapted to interjoin may be provided with corresponding dovetail protrusions and dovetail cutouts, such that the dovetail protrusion on the one edge mates with the dovetail cutout on the opposing edge. Such locking elements are in particular advantageous, when two portions of the bent sheet-metal are supposed to form a common wall, i.e. not to form a corner of the housing.

In another preferred embodiment, the pair of signal lines is arranged inside an insulating body, wherein preferably the insulating body is molded around the signal lines. The skilled person will understand, that the signal lines must not come into electrical contact with the walls of the housing, but must be insulated therefrom. By using an insulating body that separates the signal lines from each other and also from the inner walls of the housing, the signal lines are safely held in the desired position and out of contact with other electrical conductive components. The connecting ends of the signal lines preferably extend out of the insulating body to allow the desired electrical connection.

Preferably, the housing is at least partially bent around the insulating body. In the art, when using diecast produced housings, it was often difficult to mount the insulating body with the signal lines inside of the housing. In particular with 90° connections it was often necessary to split the insulating body into halves, such that each halve could be assembled into the housing from the respective mating ends thereof. By using the sheet-metal configuration of the present invention, it is now possible to fold or bend the housing around the insulating body, so that for example a single, integrated insulating body can be used. This offers substantial advantages in particular in an automatic assembly process.

In another preferred embodiment, the signal lines are provided with connecting ends in the form of press-fit/ compliant pins. Preferably, the press-fit/ compliant pins are arranged on the same end as the press-fit/ compliant pins of the shielding housing and extend in the same direction, such that the connection of the housing and the signal lines can be achieved in one single assembly step, by for example pressing all press-fit/ compliant pins into a PCB with the same pressing tool. The corresponding other end of the respective signal lines may for example also be provided with a press-fit/ compliant pin, but more preferably with a regular contact shape, such as for example in the form of a contact pin.

Preferably, the housing comprises protrusions, such as teeth, on an edge of a housing wall adapted to come into contact with the PCB, to improve the contact quality of housing and PCB. The protrusions may for example be provided in form of teeth that extend in the mating or mounting direction of the housing such that upon mounting the housing on the surface of the PCB, the teeth cut into the surface. This can be used to increase not only the structural connection with the PCB but also the electrical connection to ground. Another alternative is the provision of a single protrusion, that extends over a substantial length of the edge of the wall and that is adapted to fit in for example a corresponding slot provided in the PCB.

In yet another preferred embodiment, the housing comprises mounting means, in particular mounting hooks, adapted to fasten the housing with a corresponding insulating connector housing. For many applications it is necessary or desired that the shielding housing is in turn arranged inside of a connector housing, that is made from insulating material. The connector housing facilitates the connection of the signal lines with other electrical components, such as other connectors or a PCB etc. In order for a safe and reliable mounting of the shielding housing inside of a connector housing, the walls of the shielding housing are provided with mounting means, in particular in form of hooks, that latch onto corresponding mounting or latching apertures provided in the connector housing.

Preferably, the shielding housing is formed from a single piece of sheet-metal. By forming the shielding housing from a single piece of sheet-metal, the invention makes full use of the advantages associated with the production process, as all the different functional elements, such as the press-in pins or locking features, can be made by stamping and it is not necessary to mount these features later onto the formed housing. As the shielding housing serves for electromagnetic shielding, an integral forming offers in addition a very effective shielding function.

The present invention also relates to a connector system, comprising the shielding device of any of the preceding claims and an insulating housing, wherein the shielding device is at least partially received.

### 4. Description of the figures

In the following, the figures, which show specific embodiments of the present invention, are briefly described.
Fig. 1 schematically shows a view of a stamped shielding housing partially bent to its final shape;
Fig. 2 schematically shows a shielding device in accordance with the invention;
Fig. 3 schematically shows a data transmission arrangement to be used in connection with the housing of Fig. 1;
Fig. 4 schematically shows how the data transmission arrangement of Fig. 3 is mounted into the partially bent housing of Fig. 1;
Fig. 5 shows the arrangement of Fig. 4 with the housing bent even further into its final shape;
Fig. 6 shows the arrangement of Fig. 5 with the housing bent even further;
Fig. 7 shows the arrangement of Fig. 5 with the housing bent into its final shape;
Fig. 8 schematically shows two alternatives of improved edge designs of the housing;
Fig. 9 schematically shows another embodiment of a shielding device in accordance with the invention;
Fig. 10 shows the housing mounted to an insulating connector and a PCB; and
Fig. 11 shows the arrangement of Fig. 10 connected to a counter connector.

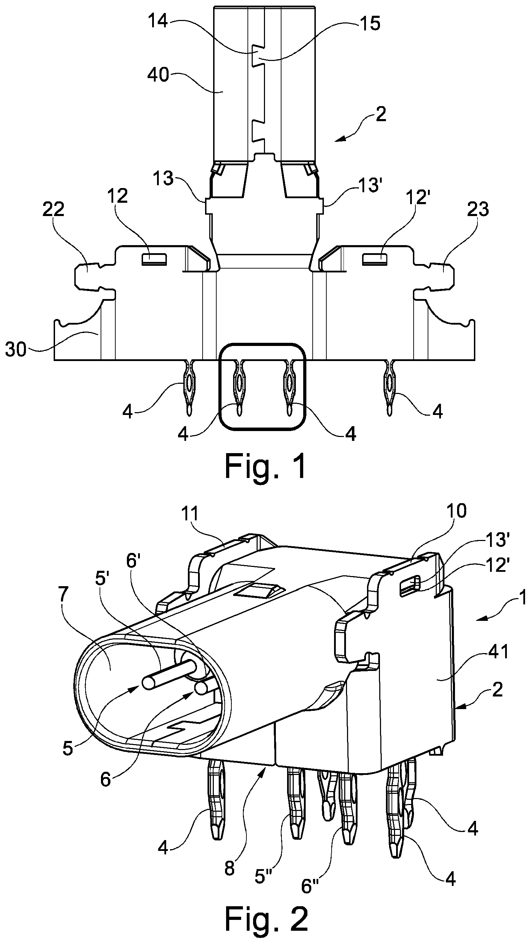

Figure 1 shows a top view of a housing 2 to made of stamped and partially bent sheet-metal. In the shown configuration, only a part of the housing is formed into its final shape, whereas the lower part (as seen in the figure) is not yet bent. As one can see, the whole housing 2 is formed by a single piece of sheet-metal, so that all features of the housing are integrally formed.

The housing comprises four press-fit/ compliant pins 4 that are adapted to be press fitted into corresponding openings in a PCB. Thereby, a connection can be established between the housing 2 and mass. The pins 4 likewise serve to structurally mount the housing onto the PCB, thus having a double function: establishing ground continuity and fixation.

The specific shield design allows all press-fits /compliant pins 4 to be in one row, so that they can be all plated in one process. In a practical manufacturing process, the housing 2 shown in Fig. 1 would be stamped into a long band of sheet metal with hundreds of housings being stamped into one band. This band can then be transported through a plating bath in a reel-to-reel plating process, which makes the plating very economic. After the plating process the stamped elements are separated and bent into the desired shape.

The housing is provided with several locking or mounting elements that serve to hold the housing in its final shape. For example, the housing 2 is provided with two locking apertures 12, 12' that are adapted to interact with corresponding locking protrusions 13, 13' as will be described in more detail further below. In addition, the upper part of housing 2 is provided with locking elements in form of a dovetail connection. The two adjoining edges of the walls of the housing abutting each other are provided with dovetail shape protrusions 15 and dovetail cut-outs 14 that are mated to provide a firm fixation.

The housing is also provided with two mounting means in form of mounting hooks 22, 23 adapted to fasten the housing to a corresponding insulating connector housing. The sheet-metal of the housing 2 is provided with folding lines, of which one is exemplarily denoted with reference number 30 in figure 1.

Figure 2 shows the shielding device 1 in its final configuration including a data transmission arrangement 3 arranged inside of housing 2 and being completely surrounded for electromagnetic shielding. A first cavity 7 for receiving first ends 5', 6' of the signal lines 5,6 defines a first direction. A second cavity 8, adapted for receiving the second ends 5", 6" of the signal lines, defines a second direction essentially perpendicular to the first direction. Thus, in the shown configuration the shielding device 1 has a 90° configuration for enabling a 90° connection of the pair of signal lines 5, 6. From figure 2, one can see how the protrusions 13, 13' extend into the apertures 12, 12' for an additional fixation of the shape of the housing. The first cavity 7 is formed by bending the sheet-metal into an oval cylindrical shape 40 and the second cavity 8 is formed by bending the sheet-metal into a box shaped structure 41.

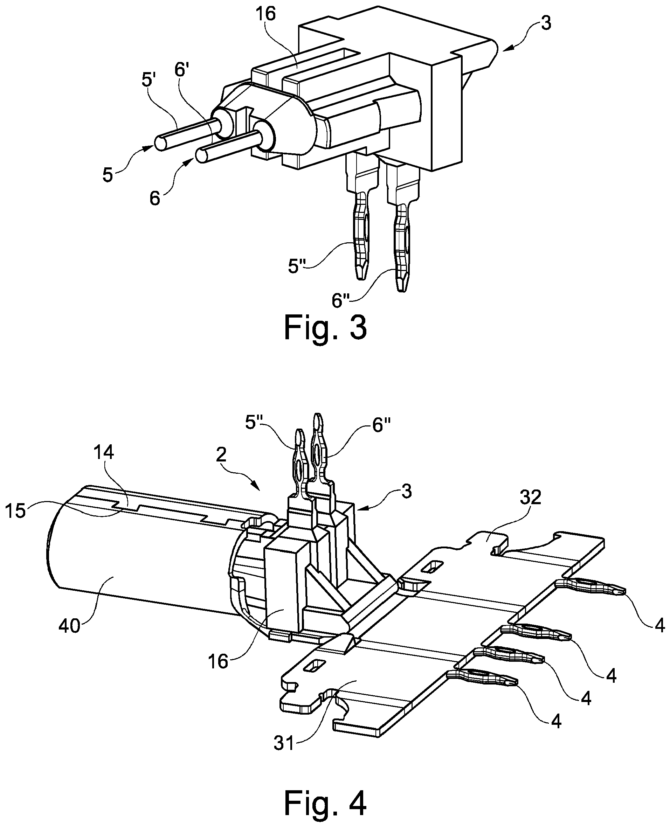

Figure 3 shows an exemplary embodiment of the pair of signal lines 5, 6 arranged inside an insulating body 16. The insulating body 16 is molded around the signal lines and encapsulates them to a large extent, except for their connecting ends. The connecting ends 5', 6' are provided in form of contact pins to establish for example electrical connection with a corresponding female contact terminal. The other ends 5", 6" are provided in the form of press-fit pins. Obviously, the shown data transmission arrangement has a 90° configuration. The insulating body 16 is made from a dielectric material and may also serve to control the crosstalk between the 2 signal lines 5, 6. Its main purpose is however to keep the signal lines in the intended position and to prevent the metallic parts thereof from coming into contact with the walls of the shielding housing 2.

Figures 4 to 7 illustrate the assembly process of the shielding device 1**.** In figure 4 the housing 2 is in the only partially bent configuration shown in figure 1**.** The first cavity 7 is already bent into its final shape and the dovetail connections 14, 15 improve the structural integrity of the oval part 40. The box shaped structure is not yet formed and the corresponding portions of the sheet-metal of housing 2 are stamped but not yet bent. In this way it is possible to easily insert the data transmission arrangement 3 into the first cavity 7 from the rear end thereof. Since the box shaped structure is not yet formed no portions of the housing 2 hinder the insertion of the data transmission arrangement 3, so that the assembly is highly facilitated and can be easily automated. As one can see, the structural features of housing 2, such as the four press-fit/ compliant pins 4, the apertures 12, 12', the hooks 22, 23 and all other features are already fully stamped out of the sheet metal, so that for finalizing the housing 2, only bending operations are required.

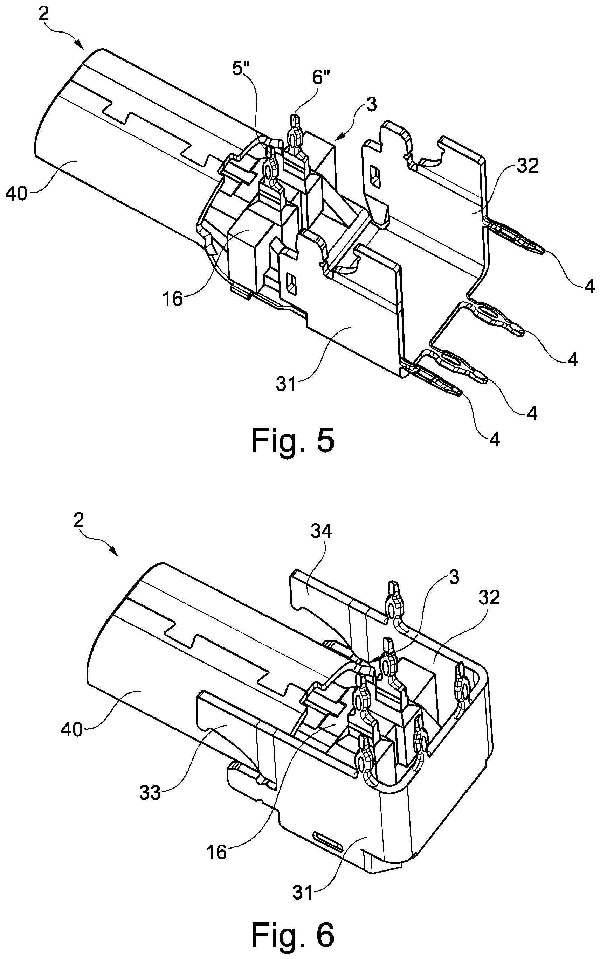

In figure 5 the left portion 31 and the right portion 32 of the unbent portion shown in Figure 4 are now bent by 90° upwardly in the orientation shown in figure 5. As the data transmission arrangement 3 is already fully inserted into the oval part 40 it is not hindering this bending operation.

In figure 6, the right hand portion of housing 2 shown in figure 5 is now likewise bent upwardly. The press-fit/ compliant pins 4 of housing 2 are arranged in line with the press-fit/ compliant pins 5", 6" of the data transmission arrangement 3 and extend in the same direction. In this way it is possible to mount the press-fit/ compliant pins 4 as well as the press-fit pins/ compliant 5", 6" of the signal lines in one single operation, by for example pressing the press-fit/ compliant pins into corresponding openings in a PCB. The configuration shown in figure 6 is not yet final. However, one can see that the locking protrusions 13, 13' extend into the locking apertures 12, 12', thereby holding the housing 2 in the configuration shown in figure 6. It is thus no longer easily possible to bend the housing 2 back into the configuration for example shown in figure 5, but first the locking means would need to be unlocked or disengaged from each other.

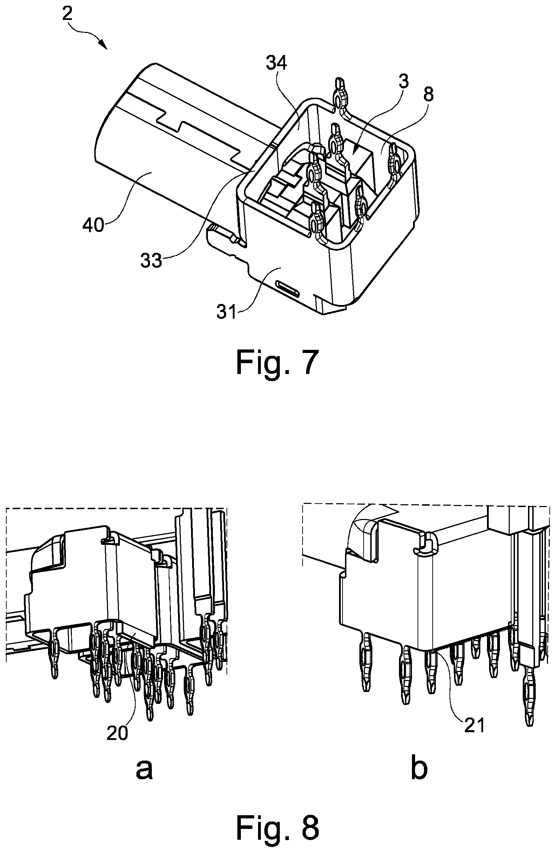

Figure 7 shows housing 2 in its final configuration. The two wing like portions 33, 34 shown in figure 6 are bent towards each other so that their respective edges abut. For improving the connection it is for example also possible to provide these contacting edges with a dovetail connection similar to the dovetail connection 14, 15 holding the walls forming the oval part 40 of the connector housing together.

Figure 8 schematically shows two alternatives for improved edge designs of the housing 2. In figure 8a to the left hand side, a single protrusion 20 is shown that extends over a substantial length of the edge of the wall and that is adapted to fit in for example a corresponding slot provided in the PCB. The right hand illustration of figure 8b shows a different solution by means of a row of teeth that extend in the mating or mounting direction of housing 2. When housing 2 is mounted to a PCB by pressing the press-fit/ compliant pins 4 and 5", 6" respectively into the corresponding openings in the PCB, the serrated teeth will cut into the surface of the PCB, thereby improving structural and electrical connection between housing 2 and PCB.

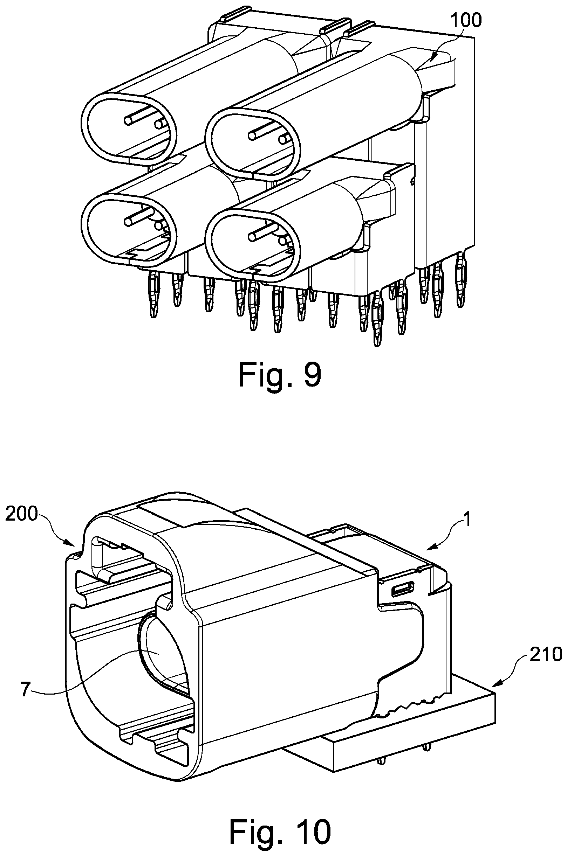

Figure 9 shows schematically how the inventive concept described in connection with figures 1 to 8 depicting a one port 90° arrangement can be scaled up to for example a four port 90° configuration 100. The present invention allows for a basically almost limitless upscaling of the idea, by using the same basic construction but with different dimensions.

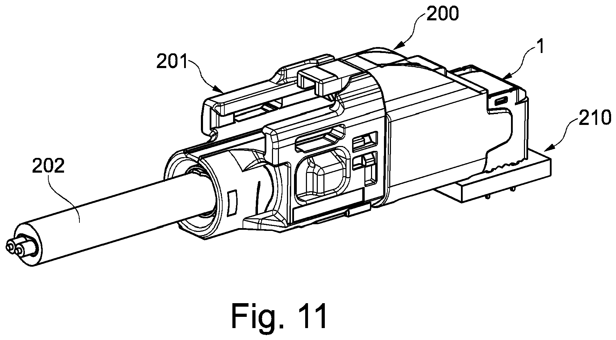

Fig. 10 shows the shielding device 1 mounted to a PCB 210. The shielding device is further mounted in an insulating connector 200 that serves to establish an electrical connection to other electrical components. In Fig. 11 it is exemplarily shown how the insulating connector 200 is mated with a insulating counter connector 201. The counter connector 201 is provided with a signal cable 202. The shown arrangement provides a 90° connection. The details of such insulating connectors and counter connectors are well known to the person skilled in the art, so that it is refrained from giving a more detailed description thereof.

## Claims

1. Shielding device (1) for electromagnetic shielding of a data transmission
arrangement (3) comprising:
a housing (2) made from bent and stamped sheet-metal, which housing (2) comprises at least one press-fit/ compliant pin (4) adapted for connecting the housing with a PCB (210);
a pair of signal lines (5, 6) being arranged inside the housing (2), so as to be electromagnetically shielded.

2. The shielding device (1) for electromagnetic shielding according to claim 1, wherein the press-fit/ compliant pin (4) is integrally formed with the housing (2).

3. The shielding device (1) for electromagnetic shielding according to any one of the preceding claims, wherein the shielding device has a 90° configuration for enabling a 90° connection of the pair of signal lines (5, 6).

4. The shielding device (1) for electromagnetic shielding according to any one of the preceding claims, wherein the housing (2) further comprises:
a first cavity (₇) for receiving a first end (5', 6') of the signal lines, which defines a first direction, and
a second cavity (8), for receiving the second end (5", 6") of the signal lines, which defines a second direction essentially perpendicular to the first direction.

5. The shielding device (1) for electromagnetic shielding according to the preceding claim, wherein the first cavity (7) is formed by bending the sheet-metal into an oval cylindrical shape (40) and the second cavity (8) is formed by bending the sheet-metal into a box-shaped structure (41).

6. The shielding device (1) for electromagnetic shielding according to any one of the preceding claims, wherein the housing (2) comprises at least one dedicated press-in surface (10, 11), adapted to be engaged by a corresponding press-in tool.

7. The shielding device (1) for electromagnetic shielding according to any one of the preceding claims, wherein the housing (2) comprises locking apertures (12, 12') and corresponding locking protrusions (13, 13'), such that upon bending the housing (2) into the dedicated shape, the locking apertures (12, 12') and locking protrusions (13, 13') interact to maintain the shape.

8. The shielding device (1) for electromagnetic shielding according to any one of the preceding claims, wherein the housing (2) comprises interacting locking elements in form of a dovetail connection (14, 15), such that upon bending the housing into the dedicated shape, the dovetail connection (14, 15) acts to maintain the shape.

9. The shielding device (1) for electromagnetic shielding according to any one of the preceding claims, wherein the pair of signal (5, 6) lines is arranged inside an insulating body (16), wherein preferably the insulating body is molded around the signal lines.

10. The shielding device (1) for electromagnetic shielding according to the preceding claim, wherein the housing (2) is at least partially bent around the insulating body (16).

11. The shielding device (1) for electromagnetic shielding according to any one of the preceding claims, wherein the signal lines (5, 6) are provided with connecting ends in the form of press-fit pins (5", 6").

12. The shielding device (1) for electromagnetic shielding according to any one of the preceding claims, wherein the housing (2) comprises one or more protrusions (20, 21), such as teeth, on an edge of a housing wall adapted to come into contact with the PCB (210), to improve the contact quality of housing and PCB.

13. The shielding device (1) for electromagnetic shielding according to any one of the preceding claims, wherein the housing (2) comprises mounting means (22, 23), in particular mounting hooks, adapted to fasten the housing with a corresponding insulating connector housing.

14. The shielding device (1) for electromagnetic shielding according to any one of the preceding claims, wherein the housing (2) is formed from a single piece of sheet-metal.

15. Connector system, comprising the shielding device (1) of any of the preceding claims and an insulating connector (200), wherein the shielding device is at least partially received.
